# FASCICULE DE BREVET EUROPEEN

(11) **EP 3 917 301 B1**
(45) Date de publication et mention de la délivrance du brevet: **08.11.2023**
(21) Numéro de dépôt: 21172309.3
(22) Date de dépôt: 05.05.2021
(51) Int. Cl.: H05K 7/20

(54) **DISPOSITIF ONDULEUR**
WECHSELRICHTERGERÄT
INVERTER DEVICE

(30) Priorité: 26.05.2020 FR 2005549
(43) Date de publication de la demande: 01.12.2021
(73) Titulaire: THALES, 92400 Courbevoie (FR)
(72) Inventeur: ABDESSELAM, Francis, 78400 Chatou (FR)
(74) Mandataire: Atout PI Laplace

(56) Documents cités:
- JP-A- 2007 335 530
- JP-A- 2013 179 743
- US-A1- 2014 198 449

## Description

L'invention se situe dans le domaine de la génération d'une tension alternative, de préférence polyphasée, à fréquence fixe à bord d'un aéronef à partir de l'énergie mécanique générée par un moteur d'une nacelle de l'aéronef fixée sur le corps d'un aéronef. L'invention se rapporte également au refroidissement de tels générateurs.

Du brevet américain US 3, 579, 143 on connaît un dispositif combiné installé dans un nacelle d'un aéronef et comprenant un système de pignonnerie configuré pour transformer la rotation d'un arbre moteur du moteur de l'avion en une rotation à vitesse constante d'un arbre secondaire auquel est couplée en rotation une machine électrique fonctionnant en génératrice et configurée pour délivrer une tension triphasée (par exemple 115 Vac, 230 Vac) à fréquence fixe (400Hz) à partir de la rotation de l'arbre secondaire à vitesse constante. Le système de pignonnerie comprend un système hydraulique, un train épicycloïdal différentiel et une pompe hydraulique.

Toutefois, ce dispositif est très coûteux. Par ailleurs, du fait de sa complexité mécanique, il présente des problèmes de fiabilité entraînant des coûts de maintenance élevés et imposant son remplacement régulier.

Du document US 2014/0198449 A1, on connaît un module de refroidissement pour des éléments de commutation d'un onduleur triphasé. Les documents JP 2013179743 A et JP2007 335530 divulguent des architectures triphasées.

Une solution pour limiter ces inconvénients consiste à prévoir un dispositif de génération comprenant une génératrice destinée à être couplée mécaniquement à l'arbre moteur, un redresseur pour redresser une tension alternative délivrée par la génératrice, un dispositif de commande du dispositif de génération afin que la tension continue délivrée par le redresseur soit fixe et un onduleur recevant en entrée la tension fixe et apte à délivrer une tension alternative triphasée de fréquence fixe. Toutefois, l'onduleur est volumineux ce qui contraint habituellement à l'installer à l'extérieur de la nacelle dans une baie avionique logée dans le volume délimité par le corps de l'aéronef. L'onduleur est refroidi à l'eau.

Par ailleurs, l'onduleur est indisponible dès qu'un interrupteur de puissance de l'onduleur est défaillant. Un but de l'invention est de limiter au moins un des inconvénients précités.

A cet effet, l'invention a pour objet un dispositif onduleur selon la revendication 1 destiné à convertir une tension continue en des phases d'une tension alternative polyphasée à une fréquence prédéterminée, le dispositif onduleur comprenant plusieurs onduleurs monophasés, par exemple trois onduleurs monophasés, l'onduleur monophasé ou chacun des onduleurs monophasés, par exemple des trois onduleurs monophasés, étant apte à délivrer une des phases de la tension alternative polyphasée, par exemple une des trois phases d'une tension alternative polyphasée, par exemple triphasée.

En variante; le dispositif onduleur est destiné à convertir une tension continue en la phase d'une tension alternative monophasée. Il comprend un onduleur monophasé apte à délivrer la phase de la tension alternative monophasée.

Le dispositif onduleur comprenant un support entourant radialement un canal de refroidissement s'étendant longitudinalement selon un axe x et dans lequel un liquide de refroidissement est destiné à circuler selon l'axe x.

Au moins un onduleur monophasé comprend une inductance de sortie torique.

Au moins une inductance torique est montée sur le support de sorte à entourer radialement le canal de refroidissement de façon à être apte à être refroidie par le liquide de refroidissement lorsque ce dernier circule dans le canal de refroidissement.

Des composants électroniques du dispositif onduleur sont montés sur le support autour du canal de refroidissement de façon à être aptes à être refroidis par le liquide de refroidissement lorsque ce dernier circule dans le canal de refroidissement.

Au moins un sous-ensemble de ces composants électroniques est en appui sur une surface radiale d'un support tubulaire massif. Le support tubulaire massif délimite radialement le canal de refroidissement.

Avantageusement, le dispositif onduleur comprend des inductances de sortie toriques montées sur le support de sorte à entourer radialement le canal de refroidissement.

Avantageusement, des inductances de sortie toriques ou les inductances de sortie toriques sont juxtaposées le long de l'axe x.

Avantageusement, chaque onduleur monophasé comprend des interrupteurs de puissance montés sur le support autour du canal de refroidissement de façon à être aptes à être refroidis par le liquide de refroidissement lorsque ce dernier circule dans le canal de refroidissement.

Avantageusement, le support comprend un support tubulaire pour interrupteurs entourant l'axe x et est délimité radialement par une première surface délimitant le canal de refroidissement et par une deuxième surface entourant radialement la première surface, les interrupteurs de puissance étant disposés autour du support tubulaire en appui sur la deuxième surface.

Avantageusement, la deuxième surface présente six faces planes réparties autour de l'axe x, deux des interrupteurs de puissance étant en appui sur chaque face plane.

Avantageusement, un onduleur monophasé délivre une phase de la tension alternative en mode différentiel.

Dans le cas de plusieurs onduleurs monophasés, chaque onduleur monophasé délivre avantageusement une des phases de la tension alternative polyphasée en mode différentiel.

L'invention se rapporte également à un ensemble de génération destiné à être couplé mécaniquement à un arbre moteur d'un moteur d'un aéronef et destiné à délivrer les phases de la tension alternative polyphasée lorsque l'arbre moteur est entraîné en rotation à vitesse variable, l'ensemble de génération comprenant une génératrice destinée à être en prise avec l'arbre de façon à générer une tension alternative à une fréquence initiale fixe, un redresseur destiné à redresser la tension alternative et un dispositif onduleur selon l'invention.

D'autres caractéristiques, détails et avantages de l'invention ressortiront à la lecture de la description faite en référence aux dessins annexés donnés à titre d'exemple et qui représentent, respectivement :
[Fig.1] La figure 1 est un schéma bloc d'un système génération selon l'invention,
[Fig.2] la figure 2 est un schéma électrique du dispositif onduleur selon l'invention,
[Fig.3] la figure 3 représente schématiquement une vue de côté d'une partie interne d'un dispositif onduleur selon l'invention et du circuit de refroidissement de ce dispositif onduleur,
[Fig.4] la figure 4 représente schématiquement en vue de face (à gauche) et en vue de côté (à droite) un support individuel sur lequel est montée une première inductance de sortie torique,
[Fig.5] la figure 5 représente schématiquement en vue de face (à gauche) et en vue de côté (à droite), la première inductance de sortie montée sur son support individuel,
[Fig.6] la figure 6 représente schématiquement en perspective (à gauche), en vue de côté (au milieu) et en coupe dans un plan de coupe perpendiculaire à l'axe x (à droite), un support pour interrupteurs de puissance,
[Fig.7] la figure 7 représente schématiquement en vue de côté (à gauche) et en coupe dans un plan de coupe A-A (à droite), le support pour interrupteurs de puissance et les interrupteurs de puissance fixés au support pour interrupteurs,

D'une figure à l'autre, les mêmes éléments sont repérés par les mêmes références.

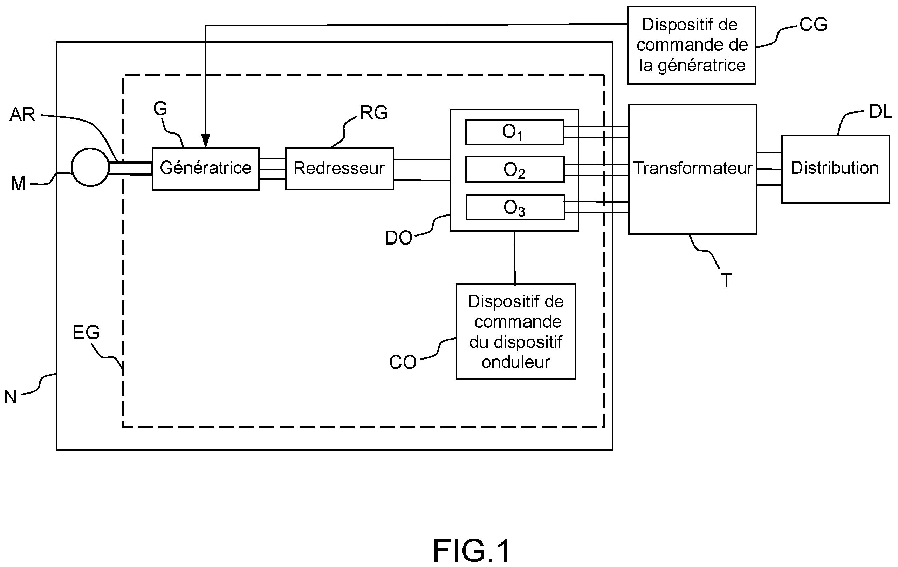

L'invention se rapporte à un système de génération tel que représenté schématiquement en figure 1. Le système de génération comprend un ensemble génératrice EG destiné à être installé dans une nacelle N d'un aéronef.

L'ensemble génératrice EG est destiné à être en prise mécanique avec un arbre moteur AR et à délivrer trois phases d'une tension alternative monophasée ou polyphasée, par exemple, triphasée à une fréquence fixe prédéterminée lorsque l'arbre moteur AR est entraîné en rotation à vitesse angulaire variable par un moteur M disposé dans la nacelle N.

Le moteur est, par exemple, destiné à entraîner la moteur en rotation dans une plage de vitesse allant de 4500 tr/min à 9000 tr/min.

L'ensemble génératrice EG comprend une génératrice G destinée à être en prise mécanique avec l'arbre moteur AR et apte à délivrer une tension alternative polyphasée présentant une même tension efficace prédéterminée, quelle que soit la vitesse de rotation de l'arbre moteur AR lorsque ce dernier est entraîné en rotation par le moteur M.

Le système de génération comprend un dispositif de commande de la génératrice CG configuré pour commander la génératrice G de sorte que la tension alternative polyphasée délivrée par la génératrice G présente la tension efficace prédéterminée quelle que soit la vitesse de rotation de l'arbre moteur AR. Le dispositif de commande de la génératrice CG comprend, par exemple, un convertisseur de puissance et un organe de commande du convertisseur de puissance. L'organe de commande est configuré pour commander le convertisseur de puissance de sorte qu'il alimente électriquement la génératrice G pour qu'elle délivre la tension alternative polyphasée souhaitée à la tension efficace prédéterminée, dont la fréquence dépend de la vitesse de rotation de l'arbre.

La génératrice G est classique pour l'homme du métier. Il s'agit, par exemple, d'une génératrice synchrone à rotor bobiné sans balais. Elle comprend alors une machine électrique principale, une excitatrice et un pont redresseur tournant reliant la machine électrique principale et l'excitatrice.

Avantageusement, la génératrice G est à trois étages. Elle comprend une génératrice auxiliaire synchrone sans balais comprenant un rotor, couplé à l'arbre commun, comprenant des aimants permanents et un stator comprenant des enroulements statoriques. En variante, la génératrice G est à deux étages.

L'ensemble génératrice EG comprend également un redresseur RG configuré pour délivrer une tension continue UE sensiblement constante lorsqu'il est soumis, en entrée, à la tensions alternative monophasée ou polyphasée générée par la génératrice G.

Avantageusement, le dispositif de commande de la génératrice est configuré pour commander la génératrice de façon qu'elle délivre une tension continue de 540 V.

L'ensemble génératrice EG comprend également un dispositif onduleur DO destiné à transformer la tension de sortie du redresseur RG en une phase d'une tension alternative monophasée ou en plusieurs phases d'une tension alternative polyphasée, par exemple en trois phases d'une tension alternative triphasée, présentant une fréquence prédéterminée fixe. L'invention se rapporte également au dispositif onduleur DO.

La phase ou les phases, par exemples les trois phases sont générées par le dispositif onduleur DO en mode différentiel.

Selon l'invention, le dispositif onduleur DO comprend un ou plusieurs onduleurs indépendants, par exemple trois onduleurs indépendants O₁, O₂, O₃, par exemple des onduleurs de tension, présentant chacun une entrée reliée à la sortie du redresseur RG de sorte à être soumis à la tension continue délivrée en sortie du redresseur RG. Chaque onduleur de tension O₁, O₂, O₃ est destiné à délivrer une tension monophasée, correspondant à une des phases de la tension alternative polyphasée par exemple monophasée, ou correspondant à la tension alternative monophasée, à fréquence fixe, à partir de la tension continue délivrée en sortie du redresseur RG.

L'ensemble génératrice EG comprend un dispositif de commande du dispositif onduleur CO configuré pour commander les onduleurs O₁, O₂, O₃, et plus particulièrement des interrupteurs électroniques commandables des onduleurs O₁, O₂, O₃, de sorte que chaque onduleur O₁, O₂, O₃ délivre une des phases de la tension alternative monopahsée ou polyphasée, par exemple triphasée de fréquence fixe et, dans le cas d'une tension alternative polyphasée, que les onduleurs, par exemple les trois onduleurs O₁, O₂, O₃ délivrent les phases de la tension alternative polyphasée, par exemple les trois phases de la tension triphasée. Ce type de commande est classique pour l'homme du métier.

Le dispositif de commande est, par exemple, configuré pour que chaque onduleur fournisse une tension alternative à 400Hz de tension efficace de 300 V, les trois tensions alternatives étant déphasées de sorte à former les phases d'une tension alternative triphasée, à partir de la tension continue de sortie du redresseur de 540 V.

Cette configuration permet d'offrir une disponibilité partielle du dispositif onduleur DO en cas de panne d'un des onduleurs dans le cas où le dispositif comprend plusieurs onduleurs.

Par ailleurs, le fait que le dispositif onduleur DO présente plusieurs onduleurs monophasés indépendants, par exemple trois onduleurs monophasé, indépendants permet une bonne intégration thermique et mécanique et un montage aisé. En effet, les composants de puissance des différents onduleurs peuvent être séparés les uns des autres.

Le dispositif de commande CO comprend avantageusement un ou des dispositifs de commande individuels, par exemple trois dispositifs de commande individuels, chaque dispositif de commande individuel étant configuré pour commander un seul des onduleurs. Le dispositif de commande est alors configuré pour synchroniser les commandes des trois dispositifs de commande individuels. La synchronisation est, par exemple, réalisée à l'aide d'un bus prioritaire de type « collecteur ouvert » composé de plusieurs, par exemple trois, signaux logiques. Dans le cas de trois onduleurs, les trois onduleurs génèrent trois signaux de synchronisation à une fréquence de prédéterminée, déphasés de 120°. Ces signaux sont mis en commun via ce bus logique : le 1 er des onduleurs qui bascule à l'état bas synchronise les deux autres onduleurs.

Le système de génération comprend avantageusement un transformateur T configuré pour réaliser une isolation galvanique entre le dispositif onduleur DO et un réseau de distribution DL de la tension polyphasée, par exemple triphasée, à bord de l'aéronef.

Le transformateur T est avantageusement configuré pour générer des phases présentant une tension efficace de distribution prédéterminée différente de celle des phases délivrées par les onduleurs. Le dispositif onduleur DO est, par exemple, configuré pour délivrer une tension alternative à 400Hz présentant une tension efficace de 115 V ou de 230 V.

Le transformateur T est avantageusement configuré pour transformer les phases délivrées par les onduleurs en mode différentiel en une tension polyphasée en mode commun, par exemple triphasée en mode commun (trois phases et neutre).

Dans la réalisation avantageuse de la figure 1, la génératrice G et le dispositif onduleur DO sont disposés dans une nacelle N d'aéronef.

Le transformateur T et le dispositif de commande de la génératrice CG sont logés dans un volume délimité par le corps de l'aéronef sur lequel est montée la nacelle N.

Dans la suite de la description, l'invention est décrite dans le cas d'un dispositif onduleur comprenant trois onduleurs mais elle s'applique, bien entendu au cas où le dispositif onduleur comprend un onduleur ou plusieurs onduleurs. Notamment, le schéma électrique, l'insertion dans le schéma électrique du dispositif onduleur, la structure et l'agencement des éléments de chacun des onduleurs peut notamment être appliqué au cas d'un dispositif onduleur comprenant un unique onduleur ou plusieurs onduleurs en nombre différents de trois.

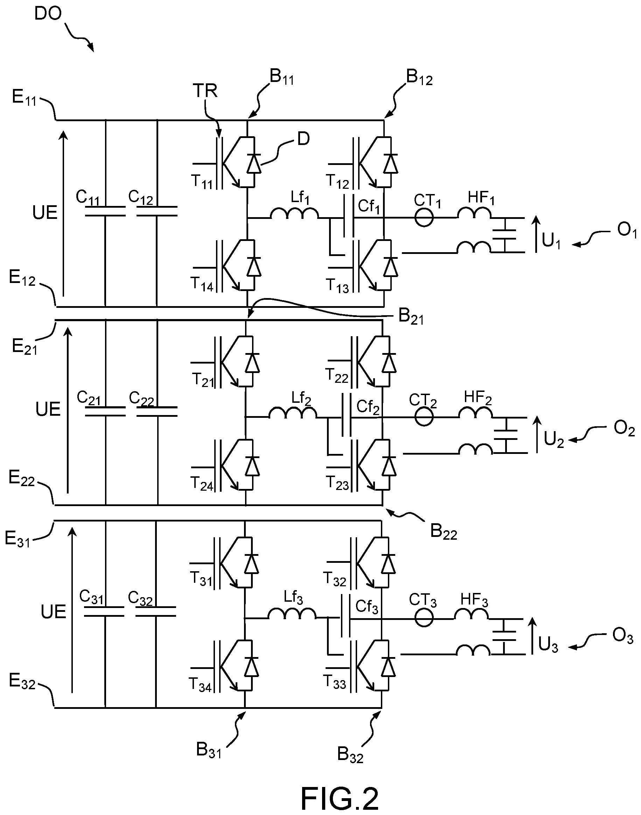

La figure 2 représente un schéma électrique des onduleurs O₁, O₂, O₃ (ou Oᵢ avec i = 1 à 3) de tension du dispositif onduleur DO. Chaque onduleur Oᵢ est soumis entre ses bornes d'entrée Eᵢ₁ et Eᵢ₂, à la tension UE de sortie du redresseur RG.

Chaque onduleur O₁, O₂, O₃ comprend des composants de puissance.

Chaque onduleur Oi comprend un filtre d'entrée comprenant deux condensateurs d'entrée Cᵢⱼ (avec j = 1 à 2) montés en parallèle entre les bornes d'entrée Eᵢ₁ et Eᵢ₂ de l'onduleur Oᵢ considéré. Les condensateurs Cᵢⱼ présentent une faible impédance permettent d'obtenir une tension fixe en sortie du filtre d'entrée. La valeur de la tension de sortie du filtre d'entrée ne varie pas en fonction d'une variation de l'appel de courant.

Chaque onduleur de tension Oᵢ (avec i= 1 à 3) comprend en outre quatre interrupteurs de puissance Tᵢₖ (avec k= 1 à 4) montés en pont en H en sortie du filtre d'entrée Cᵢⱼ (avec j = 1 à 2).

Chaque interrupteur Tᵢₖ comprend, par exemple, un transistor TR monté en parallèle avec une diode D. Le transistor est, par exemple, un transistor bipolaire à grille isolée ou IGBT en référence à l'expression anglo-saxonne « Insulated Gate Bipolar Transistor », par exemple un IGBT PNP.

Le pont en H de chaque onduleur Oᵢ comprend deux branches Bᵢ₁ et Bᵢ₂ comprenant chacune deux interrupteurs connectés en série.

Chaque onduleur de tension Oᵢ comprend un premier filtre de sortie LC comprenant une inductance de sortie Lfᵢ et un condensateur de sortie Cfᵢ connectés en série entre les deux points milieux des deux branches Bᵢ₁ et Bᵢ₂ du pont en H. Ce filtre LC est un filtre basse fréquence permettant d'obtenir une tension sinusoïdale présentant une valeur moyenne de tension nulle. La fonction de l'inductance de sortie Lfᵢ est de lisser la tension de sorte à obtenir une tension sinusoïdale en sortie de l'onduleur Oᵢ et la fonction du condensateur de sortie Cfᵢ est de supprimer un éventuel offset en tension de façon à obtenir une tension de sortie de valeur moyenne nulle.

A cet effet, la fréquence de résonance du filtre LC est très faible par rapport à la fréquence de découpage des interrupteurs de puissance.

Chaque onduleur Oᵢ comprend également un capteur de courant CTᵢ permettant de mesurer le courant de sortie de l'onduleur Oᵢ.

Le dispositif de commande du dispositif onduleur CO utilise la mesure du courant de sortie délivrée par les capteurs de courants CTᵢ des onduleurs Oᵢ pour commander les interrupteurs de puissance afin de limiter le courant de sortie lors d'une surcharge.

Avantageusement, chaque onduleur Oᵢ comprend un deuxième filtre de sortie HFᵢ passe-bas monté aux bornes du condensateur de sortie Cfᵢ de l'onduleur Oᵢ. Le deuxième filtre de sortie HFᵢ est configuré pour filtrer les signaux parasites haute fréquence générés en particulier à la fréquence de découpage des interrupteurs et à des fréquences de ses harmoniques.

Ce filtre passe bas est, par exemple, un filtre LC série présentant une fréquence de résonance de l'ordre de la fréquence de découpage.

La tension de sortie Uᵢ de chaque onduleur Oᵢ est la tension mesurée en sortie du filtre passe-bas HFᵢ.

Nous allons maintenant décrire l'architecture mécanique et thermique du dispositif onduleur DO selon l'invention.

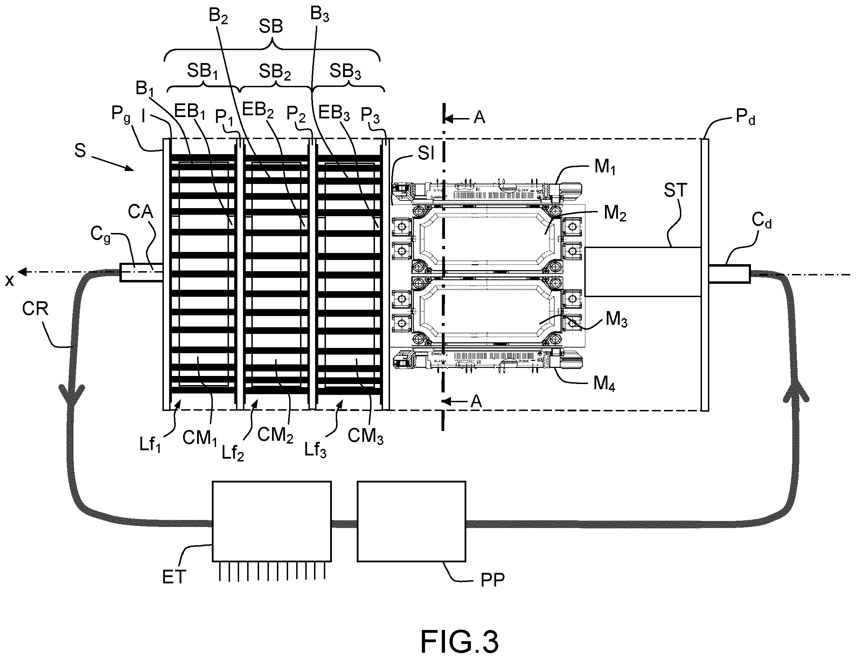

La figure 3, représente schématiquement en vue de côté, une partie interne d'un dispositif onduleur DO selon l'invention et du circuit de refroidissement CR de ce dispositif onduleur.

Le dispositif onduleur DO comprend un support S entourant radialement un canal CA allongé selon un axe x, et dans lequel est destiné à circuler un liquide de refroidissement le long de l'axe x.

Le liquide de refroidissement est destiné à circuler dans le circuit de refroidissement CR en boucle fermée. Ce circuit de refroidissement CR comprend le canal de refroidissement CA, une pompe PP et un échangeur thermique ET.

Le support S comprend avantageusement un connecteur de sortie C_{g} destiné à véhiculer un liquide de refroidissement, par exemple de l'huile ou de l'eau, sortant d'un canal de refroidissement CA vers l'échangeur thermique ET, destiné à refroidir le liquide de refroidissement, puis vers la pompe PP configurée pour faire circuler le liquide de refroidissement vers un connecteur d'entrée C_{d}, du support S, dans le sens des flèches de la figure 3, pour injecter le liquide de refroidissement dans le canal de refroidissement CA et le faire circuler le long de l'axe x jusqu'au connecteur C_{g}. Le sens de circulation du liquide pourrait bien entendu être inversé par rapport à celui de la figure 1.

Avantageusement, des composants électroniques, notamment des composants de puissance du dispositif onduleur DO sont montés sur le support S autour du canal de refroidissement CA de façon que ces composants de puissance soient aptes à être refroidis par le liquide de refroidissement lorsque ce dernier circule dans le canal de refroidissement CA.

Le canal de refroidissement CA s'étend avantageusement longitudinalement le long de l'axe x.

Ce montage est compact et aisé à réaliser. Il permet un montage dans la nacelle N ce qui permet de réduire la masse de l'ensemble.

Ce montage permet un refroidissement des composants de puissance montés autour du canal de refroidissement CA avec un même liquide de refroidissement que celui utilisé pour refroidir la machine électrique de la génératrice.

Le fait que le canal de refroidissement CA s'étende linéairement favorise l'intégration du dispositif onduleur DO.

Avantageusement, des composants électroniques Lfᵢ, Tᵢₖ de chacun des trois onduleurs Oᵢ sont montés sur le support S autour du canal de refroidissement CA de façon que ces composants de puissance soient aptes à être refroidis par le liquide de refroidissement lorsque ce dernier circule dans le canal de refroidissement CA. Cela permet de monter les composants des trois onduleurs sur la nacelle et un refroidissement des composants des trois onduleurs au moyen d'une même boucle de refroidissement.

Ces composants comprennent avantageusement les inductances de sortie Lfᵢ et les interrupteurs de puissance Tᵢₖ. En effet, ce sont les composants des onduleurs qui dissipent le plus de chaleur.

A cet effet, le support S comprend un support pour inductances SB, sur lequel sont montés les inductances de sortie Lfᵢ et un support SI pour interrupteurs sur lequel sont montés les interrupteurs de puissance Tᵢₖ.

Ces supports sont solidaires les uns des autres.

Avantageusement, les composants électroniques Lfᵢ, Tᵢₖ montés sur le support S sont destinés à être montés sur la nacelle via le support S. Cela permet un montage aisé des trois onduleurs sur la nacelle.

Avantageusement, chacun de ces composants électroniques Lfᵢ, Tᵢₖ est en appui sur une surface radiale d'un corps tubulaire massif SBᵢ, SI présentant une forme tubulaire délimitant radialement le canal de refroidissement CA. Par surface radiale du corps tubulaire, on entend une surface délimitant radialement le corps tubulaire.

Comme nous le verrons dans la suite du texte, chacun de ce ou ces corps tubulaires SBᵢ, SI est avantageusement délimité radialement par une surface interne délimitant le canal de refroidissement CA et par une surface externe entourant complètement, radialement, la surface interne. Cela permet d'obtenir un bon échange thermique entre chaque composant en appui sur le corps tubulaire et le liquide de refroidissement circulant dans le canal de refroidissement CA délimité radialement par le corps tubulaire SBᵢ, SI.

Avantageusement, chacun de ce ou ces corps tubulaire est métallique. Les métaux présentent l'avantage d'être de bons conducteurs thermiques.

Le corps métallique est, par exemple, réalisé en aluminium, présentant l'avantage d'être léger, ou en acier.

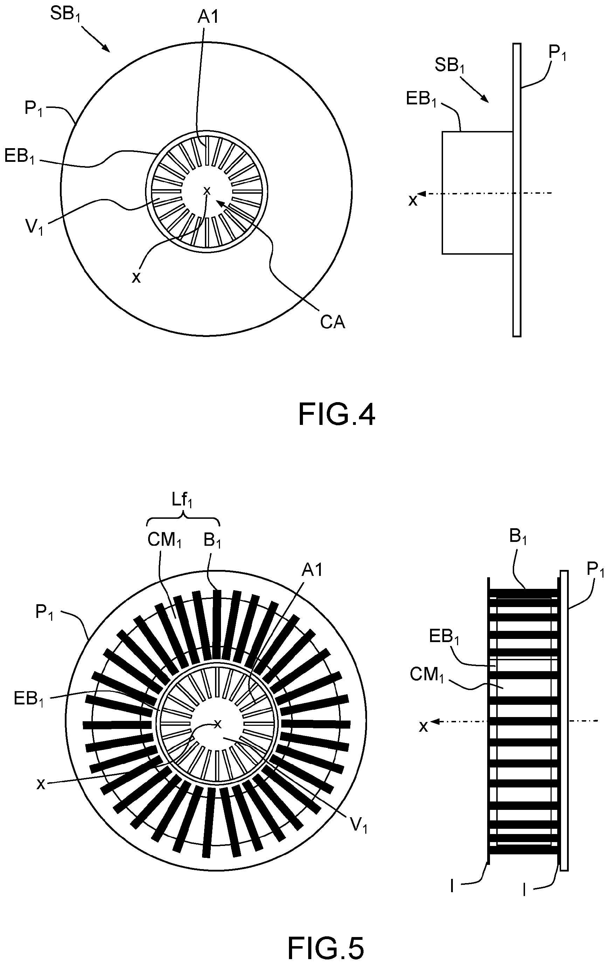

En figure 4, on a représenté schématiquement en vue de face (à gauche) et en vue de côté (à droite) un des trois supports individuels SB₁ sur lequel est montée la première inductance de sortie Lf₁. Les supports individuels sur lesquels sont montées les autres inductances de sortie sont identiques à ce support individuel.

Le support individuel d'inductance SB₁ délimite un volume interne V₁ cylindrique correspondant à une portion axiale du canal de refroidissement CA.

Le support individuel comprend une embase tubulaire EB₁ d'axe x et une plaque P₁ s'étendant dans un plan transverse perpendiculaire à l'axe x. La plaque P₁ est adjacente à l'embase tubulaire EB₁ le long de l'axe x.

La plaque P₁ adjacente à l'embase tubulaire EB₁ présente une forme de disque comprenant une ouverture présentant un diamètre sensiblement identique à celui du diamètre interne de l'embase tubulaire EB₁.

L'embase tubulaire EB₁ et la plaque P₁ entourent et délimitent radialement la portion individuelle du canal de refroidissement CA.

Le support individuel SB₁ est, avantageusement, muni de premières ailettes de refroidissement A1 s'étendant au sein du volume interne V₁.

Par exemple, les premières ailettes A1 sont réalisées sous forme de plaques s'étendant radialement au sein du canal de refroidissement CA et plus particulièrement au sein du volume V₁.

Sur la figure 5, on a représenté schématiquement en vue de face (à gauche) et en vue de côté (à droite), la première inductance de sortie Lf₁ montée sur son support individuel SB₁. La structure de chacune des deux autres inductances de sortie Lf₂, Lf₃ et leur montage ne sont pas représentés en détails car ils sont identiques à la structure de l'inductance de sortie de sortie Lf₁ et respectivement à son montage sur son support individuel SB₁.

La première inductance de sortie Lf₁ est torique et comprend un circuit magnétique torique CM₁ et un bobinage B₁ réalisé autour du circuit magnétique torique CM₁. Le bobinage B₁ est un enroulement d'un fil conducteur électriquement, par exemple, en cuivre, réalisé autour du circuit magnétique torique CM₁. Comme visible en figure 3, c'est le cas de chaque bobine de sortie Lfᵢ : elle comprend un circuit magnétique torique CMᵢ et un bobinage Bᵢ réalisé autour du circuit magnétique torique CMᵢ.

La première inductance de sortie Lf₁ entoure radialement le canal CA et plus particulièrement l'embase tubulaire EB₁,

Avantageusement, chaque inductance de sortie torique entoure complètement radialement le canal de refroidissement CA.

De façon plus générale, au moins une inductance de sortie est torique et entoure radialement le canal de refroidissement CA et plus particulièrement l'embase tubulaire.

L'inductance de puissance torique Lf₁ forme une couronne entourant l'axe x et le canal de refroidissement CA.

L'embase tubulaire EB₁ est massive.

Avantageusement, l'inductance de puissance Lf₁ est en appui radial sur l'embase tubulaire EB₁.

L'inductance de puissance Lfᵢ peut être en contact physique direct ou indirect avec l'embase tubulaire EBᵢ.

Cet agencement des inductances de puissance est particulièrement compact et permet un refroidissement efficace des inductances de puissance par un liquide circulant dans le canal de refroidissement CA.

Avantageusement, comme représenté en figure 3, les inductances de sortie toriques Lfᵢ sont disposées de façon adjacente le long de l'axe x, c'est-à-dire les unes à côté des autres le long de l'axe x. Cet agencement est particulièrement compact. Cela est également valable dans le cas d'un dispositif onduleur comprenant plusieurs onduleurs et délivrant une tension polyphasée non triphasée.

De façon plus générale, plusieurs inductances de sortie toriques sont avantageusement disposées de façon adjacente le long de l'axe.

Les volumes délimités par les différents supports individuels SBᵢ sont alors adjacents le long de l'axe x.

Comme visible en figure 3, les supports individuels SBᵢ sont accolés les uns aux autres le long de l'axe x de sorte que les embases tubulaires de deux supports individuels consécutifs SB₁ et SB₂ (respectivement SB₂ et SB₃) soient séparés par une plaque P₁ (respectivement P₂) d'un des deux supports individuels.

Le support S comprend également une plaque d'extrémité P_{g} contiguë à l'embase tubulaire EB₁ du premier support individuel SB₁.

Chaque inductance de puissance Lf₁, respectivement Lf₂, respectivement Lf₃ est interposée axialement entre deux plaques P_{g}, P₁, respectivement P₁, P₂, respectivement P₂, P₃, de sorte à être maintenue à une position axiale sensiblement fixe par rapport au support S.

Avantageusement, chaque inductance de puissance Lf₁, respectivement Lf₂, respectivement Lf₃ est séparée axialement de chacune des deux plaques P_{g}, P₁ ; respectivement P₁, P₂ ; respectivement P₂, P₃, entre lesquelles elle est interposée, par une interface thermique I.

Avantageusement, chaque interface thermique I est accolée à une des inductances de sortie toriques et à une plaque P_{g}. Les interfaces thermiques I sont isolantes électriquement et favorisent l'échange thermique entre l'inductance de sortie torique et le canal de refroidissement CA via les plaques Pᵢ, P_{g}.

L'interface thermique I, accolée à une des inductances de sortie toriques et à une plaque P_{g}, Pᵢ présente, par exemple, une forme de lame présentant une ouverture centrale entourant une des embases. Elle peut être formée d'un matériau isolant électrique présentant un coefficient de transfert thermique élevé, par exemple un polymère, comme, par exemple, le Kapton ou le polypropylène. En variante, l'interface thermique I est multicouche. Elle comprend, par exemple, de couches d'un même matériau isolant électrique séparées par un matériau à changement d'état changeant d'état lorsqu'une température seuil est dépassée de sorte que l'épaisseur de l'interface thermique diminue lorsque la température dépasse cette température seuil. Cela permet à l'interface thermique de reprendre la dilatation axiale d'une inductance de puissance lorsque la température augmente et donc de limiter les vibrations à basse température.

De préférence, comme représenté en figure 3, les interrupteurs de puissance Tᵢₖ sont disposés autour d'une deuxième zone du canal de refroidissement CA adjacente, le long de l'axe x, à une première zone du canal de refroidissement selon l'axe x autour de laquelle sont disposées les inductances de sortie toriques Lfᵢ afin que les interrupteurs Tᵢₖ soient refroidis par le liquide de refroidissement circulant dans le canal de refroidissement CA. Cela permet de disposer les interrupteurs de puissance Tᵢₖ à proximité des inductances de sortie toriques Lfᵢ tout en assurant un refroidissement efficace de ces interrupteurs.

A cet effet, le support SI pour interrupteurs de puissance est adjacent au support pour inductances SB le long de l'axe x.

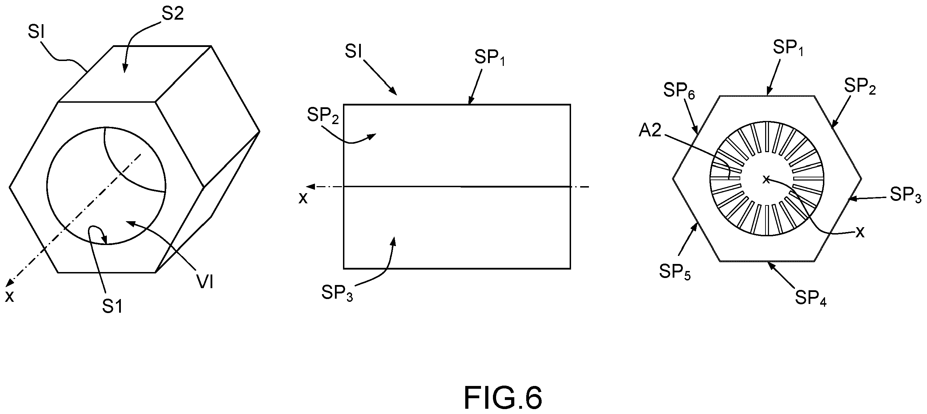

En figure 6, on a représenté schématiquement en perspective (à gauche), en vue de côté (au milieu) et en coupe dans un plan de coupe perpendiculaire à l'axe x (à droite), le support pour interrupteurs de puissance SI. Les ailettes A2 dont est muni le support SI ne sont pas représentées à gauche.

Le support pour interrupteurs de puissance SI est tubulaire et massif. Le support tubulaire SI entoure l'axe x et est délimité radialement par une première surface S1 délimitant le volume VI qui est une portion axiale du canal de refroidissement CA, et par une deuxième surface S2, entourant radialement la première surface S1 et sur laquelle sont fixés les interrupteurs de puissance Tᵢₖ.

Avantageusement, la deuxième surface S2 comprend au moins une face plane SPₘ (m = 1 à 6).

Dans la réalisation avantageuse de la figure 6, la deuxième surface S2 présente une forme globalement hexagonale dans un plan perpendiculaire à l'axe x de sorte à présenter six faces planes SPₘ réparties autour de l'axe x.

Les faces planes SPₘ s'étendent longitudinalement selon l'axe x.

Le support pour interrupteurs de puissance SI est avantageusement muni de deuxièmes ailettes de refroidissement A2 en saillie sur la première surface S1 de sorte à s'étendre au sein du canal de refroidissement CA.

Par exemple, les deuxièmes ailettes A2 sont réalisées sous forme de plaques s'étendant radialement au sein du canal de refroidissement CA.

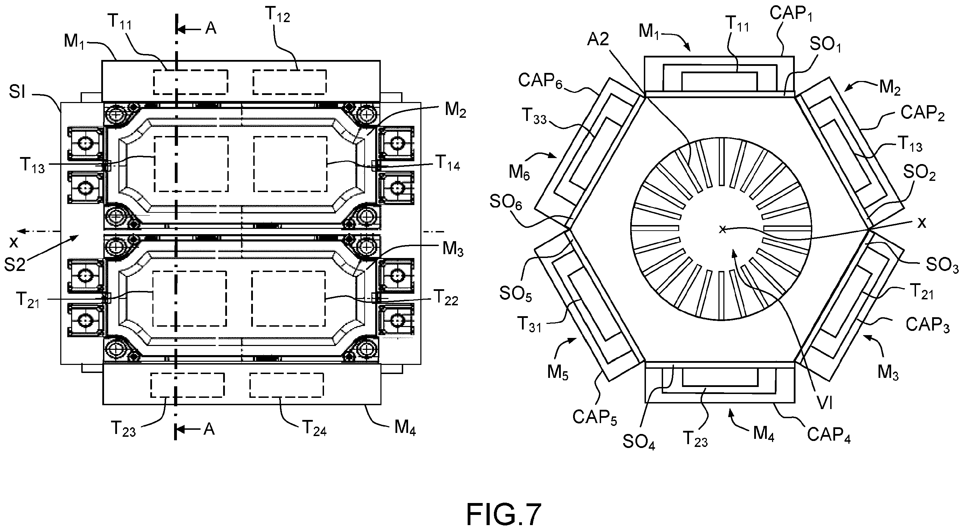

En figure 7, on a représenté schématiquement en vue de côté (à gauche) et en coupe dans le plan AA (à droite), le support pour interrupteurs de puissance SI et les interrupteurs de puissance Tᵢₖ fixés au support pour interrupteurs SI.

Avantageusement, l'ensemble d'interrupteurs de puissance Tᵢₖ est disposé radialement autour du support pour interrupteur SI, en appui sur la deuxième surface S2.

Avantageusement, l'ensemble d'interrupteurs de puissance Tᵢₖ comprend des interrupteurs de puissance répartis radialement autour du support pour interrupteurs de puissance SI. Cela permet un bon refroidissement des différents interrupteurs de puissance Tᵢₖ.

Avantageusement, les interrupteurs de puissance Tᵢₖ sont en appui sur différentes faces planes SPₘ de la deuxième surface S2 ou sur les différentes faces planes de la deuxième surface S2. Cela permet d'assurer un refroidissement efficace de l'interrupteur de puissance en accolant une face plane de l'interrupteur de puissance ou d'un support sur lequel est monté l'interrupteur de puissance contre une des faces planes axiales de support SI.

Dans la réalisation non limitative des figures, le dispositif onduleur DO comprend des modules de puissance Mₘ. Chaque module de puissance Mₘ comprend un socle sensiblement plan SOₘ (m = 1 à 6) et deux interrupteurs de puissance Tᵢₖ.

Au moins une face plane de chaque interrupteur Tᵢₖ est accolée à une surface plane d'un des socles SOₘ lui-même en appui sur une des faces planes SPₘ de façon à présenter une grande surface d'échange thermique entre l'interrupteur et le support SI ce qui favorise le refroidissement de l'interrupteur par le liquide de refroidissement circulant dans le canal CA.

Chaque module Mₘ comprend avantageusement un capot CAPₘ. Les deux interrupteurs du module Mₘ sont interposés entre le capot CAPₘ et le socle du module SOₘ.

Dans la réalisation avantageuse des figures, deux interrupteurs de puissance sont en appui sur chacune des six faces planes de la deuxième surface S2.

Autrement dit, chaque module de puissance Mₘ est en appui sur une des faces planes SPₘ de la deuxième surface S2.

Avantageusement, comme visible en figure 7, chaque module de puissance Mₘ comprend les deux interrupteurs d'un même bras du pont d'un des trois onduleurs. Cela permet de faciliter l'installation et les branchements.

Chaque module de puissance Mₘ s'étend longitudinalement selon l'axe x et les deux interrupteurs de puissance du module de puissance sont adjacents le long de l'axe x. Seuls les interrupteurs T₃₂ et T₃₄ ne sont, par conséquent, pas visibles en figure 7.

Par conséquent, dans la réalisation particulière des figures, les interrupteurs de puissance sont répartis radialement autour du canal CA et axialement le long du canal CA.

En variante, les interrupteurs de puissance sont répartis uniquement axialement autour de l'axe x. Cela favorise l'uniformité du refroidissement de chacun des interrupteurs.

De façon plus générale, la deuxième surface S2 comprend au moins une face plane et au moins un interrupteur de puissance est fixé contre la face plane. Le nombre de faces planes de la deuxième surface visibles sur les figures n'est pas limitatif. On peut, par exemple, envisager une deuxième surface présentant globalement une forme de polygone présentant un nombre de côtés différent de six dans le plan perpendiculaire à l'axe x.

On peut, par exemple, envisager une deuxième surface présentant globalement une forme de dodécagone de sorte à présenter douze faces planes. On peut alors mettre un interrupteur en appui sur chacune des faces. En variante, on peut envisager une deuxième surfaces présentant globalement une forme de triangle de sorte à présenter trois faces planes. On peut alors mettre en appui quatre interrupteurs sur chacune des faces.

De façon générale, la deuxième surface S2 comprend avantageusement différentes faces planes réparties autour de l'axe x. Des interrupteurs de puissance sont en appui sur au moins un sous ensemble de ces faces planes.

Le nombre de modules de puissance et le nombre d'interrupteurs de puissance par module de puissance ne sont pas limitatifs. On peut envisager plusieurs supports intermédiaires par interrupteur de puissance ou bien un ou plus de deux interrupteurs par support intermédiaire.

Avantageusement, tous les composants électroniques du dispositif onduleur DO sont montés sur le support S et disposés autour du canal de refroidissement CA dans un volume cylindrique représenté en traits pointillés sur figure 3, dont l'axe est l'axe x du canal de refroidissement CA. Cela facilite l'intégration du dispositif onduleur DO dans la nacelle N et son montage sur la nacelle. Ce montage est particulièrement compact.

Le volume cylindrique est délimité axialement par la plaque P_{g} et par une autre plaque d'extrémité P_{d} perpendiculaire à l'axe x.

Avantageusement, le dispositif de commande du dispositif onduleur CO est avantageusement intégré dans ce volume cylindrique.

Dans la réalisation non limitative de la figure 3, le support S comprend un support tubulaire d'extrémité ST délimitant radialement le canal de refroidissement et contigu au support pour interrupteurs SI mais pourrait, en variante, être contigu au support pour inductances SB.

Les composants électroniques autres que les interrupteurs et les inductances de sortie toriques peuvent être disposés radialement autour du support tubulaire d'extrémité ST et/ou autour des interrupteurs de puissance. Cela permet de limiter le diamètre du volume cylindrique occupé par les composants du dispositif onduleur.

En variante, les composants du dispositif onduleurs DO autres que les interrupteurs de sortie et que les inductances de sortie peuvent être disposés radialement autour du support tubulaire d'extrémité ST et/ou autour des interrupteurs et/ou autour des inductances de sortie.

Le support S peut être monobloc ou être un assemblage de pièces assemblées de façon étanche de façon à éviter un écoulement de liquide du canal de refroidissement vers les composants électroniques.

Le dispositif onduleur DO comprend avantageusement un boîtier renfermant les composants électroniques du dispositif onduleur de façon étanche.

Le boîtier comprend, par exemple, un capot tubulaire relié de façon étanche aux plaques d'extrémité P_{g} et P_{d}.

Le canal de refroidissement entoure l'axe x.

Avantageusement, le canal de refroidissement CA est à symétrie de révolution autour de l'axe x.

Avantageusement, au moins un des supports tubulaires est à symétrie de révolution autour de l'axe x.

## Revendications

1. Dispositif onduleur (DO) destiné à convertir une tension continue en une phase d'une tension alternative à une fréquence prédéterminée, le dispositif onduleur (DO) comprenant un onduleur monophasé (O₁, O₂, O₃) apte à délivrer la phase, l'onduleur monophasé comprenant une inductance de sortie torique, le dispositif onduleur comprenant un support (S) entourant radialement un canal de refroidissement (CA) s'étendant longitudinalement selon un axe x et dans lequel un liquide de refroidissement est destiné à circuler selon l'axe x, l'inductance torique étant montée sur le support (S) de sorte à entourer radialement le canal de refroidissement (CA) de façon à être apte à être refroidie par le liquide de refroidissement lorsque ce dernier circule dans le canal de refroidissement (CA), le dispositif onduleur (DO) comprenant des composants électroniques montés sur le support autour du canal de refroidissement de façon à être aptes à être refroidis par le liquide de refroidissement lorsque ce dernier circule dans le canal de refroidissement (CA), le support (S) comprenant un support tubulaire massif délimitant radialement le canal de refroidissement (CA), au moins un sous-ensemble des composants électroniques montés sur le support (S) autour du canal de refroidissement (CA) de façon à être aptes à être refroidis par le liquide de refroidissement lorsque ce dernier circule dans le canal de refroidissement (CA) étant en appui sur une surface radiale du support tubulaire massif, le support tubulaire comprenant une embase tubulaire (EB1) d'axe x et une plaque (P1) s'étendant dans un plan transverse perpendiculaire à l'axe x, la plaque (P1) étant adjacente à l'embase tubulaire (EB1) le long de l'axe x, l'embase tubulaire (EB1) et la plaque (P1) entourant et délimitant radialement la portion individuelle du canal de refroidissement (CA).

2. Dispositif onduleur (DO) selon la revendication 1, dans lequel le dispositif onduleur (DO) est destiné à convertir une tension continue en plusieurs phases d'une tension alternative polyphasée à une fréquence prédéterminée, le dispositif onduleur comprenant plusieurs onduleurs monophasés, chacun des onduleurs monophasés étant apte à délivrer une des phases de la tension alternative polyphasée.

3. Dispositif onduleur selon la revendication 2, dans lequel chacun des onduleurs monophasés est destiné à délivrer une des phases de la tension alternative polyphasée en mode différentiel.

4. Dispositif onduleur (DO) selon l'une quelconque des revendications 2 à 3, dans lequel le dispositif onduleur est destiné à convertir une tension continue en trois phases d'une tension alternative triphasée à une fréquence prédéterminé, comprenant trois onduleurs monophasés, chacun des onduleurs monophasés étant destiné à délivrer une des phases de la tension alternative triphasée.

5. Dispositif onduleur selon l'une quelconque des revendications 2 à 4, comprenant au moins une inductance de sortie torique montée sur le support (S) de sorte à entourer radialement le canal de refroidissement (CA).

6. Dispositif onduleur selon l'une quelconque des revendications 2 à 5, dans lequel des inductances de sortie toriques sont juxtaposées le long de l'axe x.

7. Dispositif onduleur (DO) selon l'une quelconque des revendications précédentes, dans lequel l'onduleur monophasé comprend des interrupteurs de puissance montés sur le support (S) autour du canal de refroidissement de façon à être refroidis par le liquide de refroidissement lorsque ce dernier circule dans le canal de refroidissement.

8. Dispositif onduleur (DO) selon la revendication 7, dans lequel le support (S) comprend un support tubulaire pour interrupteurs (SI) entourant l'axe x et est délimité radialement par une première surface (S1) délimitant le canal de refroidissement (CA) et par une deuxième surface (S2) entourant radialement la première surface (S1), les interrupteurs de puissance étant disposés autour du support tubulaire en appui sur la deuxième surface (S2).

9. Dispositif onduleur (DO) selon la revendication 8 en ce qu'elle dépend de l'une quelconque des revendications 2 à 6, dans lequel la deuxième surface (S2) présente six faces planes réparties autour de l'axe x, deux des interrupteurs de puissance étant en appui sur chacune des faces planes.

10. Dispositif onduleur selon l'une quelconque des revendications précédentes, dans lequel l'onduleur est destiné à délivrer la phase en mode différentiel.

11. Ensemble de génération (EG) destiné à être couplé mécaniquement à un arbre moteur (AR) d'un moteur d'un aéronef et destiné à délivrer les phases de la tension alternative polyphasée lorsque l'arbre moteur est entraîné en rotation à vitesse variable, l'ensemble de génération (EG) comprenant une génératrice (G) destinée à être en prise avec l'arbre de façon à générer une tension alternative à une fréquence initiale fixe, un redresseur destiné à redresser la tension alternative et le dispositif onduleur (DO) selon l'une quelconque des revendications précédentes.

## Patentansprüche

1. Wechselrichtergerät (DO), das zum Umwandeln einer Gleichspannung in eine Phase einer Wechselspannung mit einer vorbestimmten Frequenz bestimmt ist, wobei das Wechselrichtergerät (DO) einen einphasigen Wechselrichter (O₁, O₂, O₃) umfasst, der die Phase liefern kann, wobei der einphasige Wechselrichter einen torischen Ausgangsinduktor umfasst, wobei das Wechselrichtergerät einen Träger (S) umfasst, der einen Kühlkanal (CA) radial umgibt, der sich longitudinal entlang einer Achse x erstreckt und in dem eine Kühlflüssigkeit entlang der Achse x zirkulieren soll, wobei der torische Induktor so auf dem Träger (S) angebracht ist, dass er den Kühlkanal (CA) radial umgibt, so dass er von der Kühlflüssigkeit gekühlt werden kann, wenn diese in dem Kühlkanal (CA) zirkuliert, wobei das Wechselrichtergerät (DO) elektronische Komponenten umfasst, die auf dem Träger um den Kühlkanal herum so angebracht sind, dass sie durch die Kühlflüssigkeit gekühlt werden können, wenn diese in dem Kühlkanal (CA) zirkuliert, wobei der Träger (S) einen massiven rohrförmigen Träger umfasst, der den Kühlkanal (CA) radial begrenzt, wobei mindestens eine Teilmenge der elektronischen Komponenten auf dem Träger (S) auf einer radialen Oberfläche des massiven rohrförmigen Trägers aufliegend so um den Kühlkanal (CA) herum angebracht sind, dass sie durch die Kühlflüssigkeit gekühlt werden können, wenn diese in dem Kühlkanal (CA) zirkuliert, wobei der rohrförmige Träger einen rohrförmigen Sockel (EB1) mit der Achse x und eine Platte (P1) umfasst, die sich in einer Querebene lotrecht zur Achse x erstreckt, wobei die Platte (P1) entlang der Achse x an den rohrförmigen Sockel (EB1) angrenzt, wobei der rohrförmige Sockel (EB1) und die Platte (P1) den individuellen Abschnitt des Kühlkanals (CA) radial umgeben und begrenzen.

2. Wechselrichtergerät (DO) nach Anspruch 1, wobei das Wechselrichtergerät (DO) zum Umwandeln einer Gleichspannung in mehrere Phasen einer mehrphasigen Wechselspannung mit einer vorbestimmten Frequenz bestimmt ist, wobei das Wechselrichtergerät mehrere einphasige Wechselrichter umfasst, wobei jeder der einphasigen Wechselrichter eine der Phasen der mehrphasigen Wechselspannung liefern kann.

3. Wechselrichtergerät nach Anspruch 2, wobei jeder der einphasigen Wechselrichter zum Liefern einer der Phasen der mehrphasigen Wechselspannung im Differenzmodus bestimmt ist.

4. Wechselrichtergerät (DO) nach einem der Ansprüche 2 bis 3, wobei das Wechselrichtergerät zum Umwandeln einer Gleichspannung in drei Phasen einer dreiphasigen Wechselspannung mit einer vorbestimmten Frequenz bestimmt ist und drei einphasige Wechselrichter umfasst, wobei jeder der einphasigen Wechselrichter zum Liefern einer der Phasen der dreiphasigen Wechselspannung bestimmt ist.

5. Wechselrichtergerät nach einem der Ansprüche 2 bis 4, das mindestens einen torischen Ausgangsinduktor umfasst, der so am Träger (S) angebracht ist, dass er den Kühlkanal (CA) radial umgibt.

6. Wechselrichtergerät nach einem der Ansprüche 2 bis 5, wobei die torischen Ausgangsinduktoren entlang der Achse x nebeneinander angeordnet sind.

7. Wechselrichtergerät (DO) nach einem der vorhergehenden Ansprüche, wobei der einphasige Wechselrichter Leistungsschalter umfasst, die so auf dem Träger (S) um den Kühlkanal herum angebracht sind, dass sie von der Kühlflüssigkeit gekühlt werden, wenn diese durch den Kühlkanal fließt.

8. Wechselrichtergerät (DO) nach Anspruch 7, wobei der Träger (S) einen rohrförmigen Träger für Schalter (SI) umfasst, der die Achse x umgibt und radial durch eine den Kühlkanal (CA) begrenzende erste Fläche (S1) und durch eine die erste Fläche (S1) radial umgebende zweite Fläche (S2) begrenzt ist, wobei die Leistungsschalter um den rohrförmigen Träger herum angeordnet sind und auf der zweiten Fläche (S2) aufliegen.

9. Wechselrichtergerät (DO) nach Anspruch 8 in Abhängigkeit von einem der Ansprüche 2 bis 6, wobei die zweite Fläche (S2) sechs ebene Flächen aufweist, die um die Achse x verteilt sind, wobei zwei der Leistungsschalter auf jeder der ebenen Flächen aufliegen.

10. Wechselrichtergerät nach einem der vorhergehenden Ansprüche, wobei der Wechselrichter zum Liefern der Phase im Differenzmodus bestimmt ist.

11. Generatoranordnung (EG), die zum mechanischen Koppeln mit einer Antriebswelle (AR) eines Triebwerks eines Luftfahrzeugs und zum Liefern der Phasen der mehrphasigen Wechselspannung bestimmt ist, wenn die Antriebswelle mit variabler Geschwindigkeit in Drehung versetzt wird, wobei die Generatoranordnung (EG) einen Generator (G), der zum Ineingriffkommen mit der Welle bestimmt ist, um eine Wechselspannung mit einer festen Anfangsfrequenz zu erzeugen, einen Gleichrichter zum Gleichrichten der Wechselspannung und das Wechselrichtergerät (DO) nach einem der vorhergehenden Ansprüche umfasst.

## Claims

1. An inverter device (DO) intended to convert a DC voltage into one phase of an AC voltage at a predetermined frequency, the inverter device (DO) comprising a single-phase inverter (O₁, O₂, O₃) able to deliver the phase, the single-phase inverter comprising a toric output inductor, the inverter device comprising a support (S) radially surrounding a cooling channel (CA) extending longitudinally along an axis x and in which a cooling liquid is intended to flow along the axis x, the toric inductor being mounted on the support (S) so as to radially surround the cooling channel (CA) so as to be able to be cooled by the cooling liquid when the latter flows in the cooling channel (CA), the inverter device (DO) comprising electronic components mounted on the support around the cooling channel so as to be able to be cooled by the cooling liquid when the latter flows in the cooling channel (CA), the support (S) comprising a solid tubular support radially defining the cooling channel (CA), at least a sub-assembly of the electronic components mounted on the support (S) around the cooling channel (CA) so as to be able to be cooled by the cooling liquid when the latter flows in the cooling channel (CA) bearing on a radial surface of the solid tubular support, the tubular support comprising a tubular base section (EB1) with the axis x and a plate (P1) extending in a transverse plane perpendicular to the axis x, the plate (P1) being adjacent to the tubular base section (EB1) along the axis x, the tubular base section (EB1) and the plane (P1) surrounding and radially defining the individual portion of the cooling channel (CA).

2. The inverter device (DO) according to claim 1, wherein the inverter device (DO) is intended to convert a DC voltage into multiple phases of a polyphase AC voltage at a predetermined frequency, the inverter device comprising multiple single-phase inverters, each of the single-phase inverters being able to deliver one of the phases of the polyphase AC voltage.

3. The inverter device according to claim 2, wherein each of the single-phase inverters is intended to deliver one of the phases of the polyphase AC voltage in differential mode.

4. The inverter device (DO) according to any one of claims 2 to 3, wherein the inverter device is intended to convert a DC voltage into three phases of a three-phase AC voltage with a predetermined frequency, comprising three single-phase inverters, each of the single-phase inverters being intended to deliver one of the phases of the three-phase AC voltage.

5. The inverter device according to any one of claims 2 to 4, comprising at least one toric output inductor mounted on the support (S) so as to radially surround the cooling channel (CA).

6. The inverter device according to any one of claims 2 to 5, wherein toric output inductors are juxtaposed along the axis x.

7. The inverter device (DO) according to any one of the preceding claims, wherein the single-phase inverter comprises power switches mounted on the support (S) around the cooling channel so as to be cooled by the cooling liquid when the latter flows in the cooling channel.

8. The inverter device (DO) according to claim 7, wherein the support (S) comprises a tubular support for switches (SI) surrounding the axis x and is radially defined by a first surface (S1) defining the cooling channel (CA) and by a second surface (S2) radially surrounding the first surface (S1), the power switches being arranged around the tubular support, bearing on the second surface (S2).

9. The inverter device (DO) according to claim 8, when dependant on any one of claims 2 to 6, wherein the second surface (S2) has six planar faces distributed around the axis x, two of the power switches bearing on each of the planar faces.

10. The inverter device according to any one of the preceding claims, wherein the inverter is intended to deliver the phase in differential mode.

11. A generator set (EG) intended to be mechanically coupled to a motor shaft (AR) of a motor of an aircraft and intended to deliver the phases of the polyphase AC voltage when the motor shaft is driven in rotation at a variable speed, the generator set (EG) comprising a generator (G) intended to engage with the shaft so as to generate an AC voltage at a fixed initial frequency, a rectifier intended to rectify the AC voltage and the inverter device (DO) according to any one of the preceding claims.
